# EUROPEAN PATENT APPLICATION

(11) **EP 4 739 029 A1**
(43) Date of publication of application: **06.05.2026**
(21) Application number: 25207922.3
(22) Date of filing: 10.10.2025
(51) Int. Cl.: H10D 30/66, H10D 62/10, H10D 64/00, H10D 64/27, H10D 30/01

(54) **SPLIT-GATE MOSFET WITH REDUCED ON RESISTANCE AND REDUCED GATE-DRAIN CAPACITY**

(30) Priority: 30.10.2024 IT 202400024273
(71) Applicant: STMicroelectronics International N.V., 1228 Plan-les-Ouates, Geneva (CH)
(72) Inventor: ENEA, Vincenzo, 96100 SIRACUSA (IT)
(74) Representative: Studio Torta S.p.A.

(57) **Abstract**

Electronic device (10), comprising: a semiconductor body (12); trenches (13) in the semiconductor body (12); an insulating field plate region (14) in each trench (13); a conductive gate region (15) in each trench (13), electrically insulated from the semiconductor body (12) by means of the respective insulating field plate region (14); a field plate region (16) in each trench (13); gate interconnections (28) within the semiconductor body (12), lateral to the trenches (13), electrically insulated from the semiconductor body (12) and electrically connected to the conductive gate regions (15) in such a way as to electrically interconnect the conductive gate regions (15) with each other; and body regions (17). The ones of the conductive gate regions (15) and the gate interconnections (28) are part of respective inactive gate structures (22') of the electronic device (10), adapted to locally inhibit the formation of a conduction channel through the body regions (17), and the others of the conductive gate regions (15) and gate interconnections (28) are part of respective active gate structures (22") of the electronic device (10), adapted to locally allow the formation of a conduction channel through the body regions (17).

## Description

### TECHNICAL FIELD

The present invention relates to a split-gate MOSFET with reduced on-resistance and reduced gate-drain capacity, in particular to an electronic device with gate interconnections that increase the channel perimeter and the conduction area and with a locally selectively inactivated conduction channel. Furthermore, it relates to a manufacturing process of the electronic device.

### BACKGROUND

MOSFET ("Metal-Oxide-Semiconductor Field-Effect Transistor") technology is now widely recognized as an excellent option for several applications, for example for switches in power supply management circuits.

Commercially available now for decades, vertical diffused MOSFET (VDMOS) devices have seen significant commercial spread by virtue of their improved electrical performances. However, for a long time, VDMOSFETs have had a high on-state resistance that limited their current handling capabilities.

This problem has been overcome with "trench-gate" MOSFETs. By virtue of the vertical-direction channel, these devices allow a reduction in cell pitch without negatively affecting current spread. In particular, the introduction of devices that use a field plate, insulated from the gate electrode and connected to the source potential, as an extension of the gate electrode has enabled the lateral depletion of the off-state drift region. Since the field plate is electrically insulated from the gate electrode, this structure is also known as "shielded-gate" or "split-gate" structure.

Split-gate technology offers significant advantages with respect to previous MOSFETs, for example an improved on-resistance with respect to the active area extension and reduced gate-drain capacity. In fact, the split-gate structure allows the use of high doping concentrations, leading to significant improvements in MOSFET performances.

As is known, one of the main goals in the development of split-gate power MOSFET devices is the reduction of the on-resistance.

This may be achieved in the prior art by reducing the main resistive contributions and/or by increasing the ratio between the conduction area and the channel perimeter with respect to the total area of the device.

However, since in the known solutions the elementary cell has a strip shape, the main limitation to achieve these objectives according to the known solutions is the reduction of the dimensions of the elementary cell of the MOSFET, which implies the need to resize the diffusion process and to increase the lithographic resolution to reduce the transversal dimension of the strip. As is evident, this implies significant additional costs and difficulties during the manufacturing step.

Furthermore, a further significant issue is that, as the channel perimeter and area increase, if on the one hand the on-resistance is reduced, on the other hand there is an increase in the gate-drain capacity, i.e. the capacity Cᵣₛₛ (or Miller capacity Cₘᵢₗₗₑᵣ), and therefore an increase in the amount of gate charge Q_{g}. This entails longer switching times, power and efficiency losses and consequently has a negative impact on the figure of merit (FOM=Rₛᵢₗ*Q_{g} or FOM=Rₒₙ*Q_{g}), because the greater gate charge Q_{g} would partly compensate for the benefit resulting from the reduction of the on-resistance.

In other words, there is currently a trade-off between the reduction of the on-resistance through the increase of the channel perimeter and the reduction of the gate-drain capacity. This trade-off is a design constraint that complicates the design and limits the final performances of the MOSFET.

The aim of the present invention is to provide an electronic device and a manufacturing process of the electronic device which overcome the drawbacks of the prior art and which in particular achieve a significant increase in the conduction area without a corresponding increase in the channel perimeter and the related drain-gate capacity.

### SUMMARY

According to the present invention, an electronic device and a manufacturing process of the electronic device are provided, as defined in the annexed claims which form an integral part of the present description.

### BRIEF DESCRIPTION OF THE DRAWINGS

For a better understanding of the present invention, a preferred embodiment is now described, purely by way of non-limiting example, with reference to the attached drawings, wherein:
- Figure 1 shows a schematic perspective view along two different section lines of an electronic device, according to one embodiment;
- Figures 2A and 2B show cross-section views of details of the electronic device of Figure 1;
- Figures 3A-3C show top views of the electronic device of Figure 1, according to respective embodiments;
- Figures 4A-4M show schematic perspective views along two different section lines of steps of one embodiment of a manufacturing process of the electronic device of Figure 1;
- Figures 5A-5H show schematic perspective views along two different section lines of steps of a different embodiment of the manufacturing process of the electronic device of Figure 1;
- Figure 6 shows a schematic perspective view along two different section lines of an electronic device, according to a different embodiment; and
- Figures 7A and 7B show cross-section views of details of the electronic device of Figure 6.

In particular, the Figures are shown with reference to a triaxial Cartesian system defined by an X axis, a Y axis and a Z axis, orthogonal to each other.

In the following description, elements common to the different embodiments have been indicated with the same reference numbers.

### DETAILED DESCRIPTION OF THE INVENTION

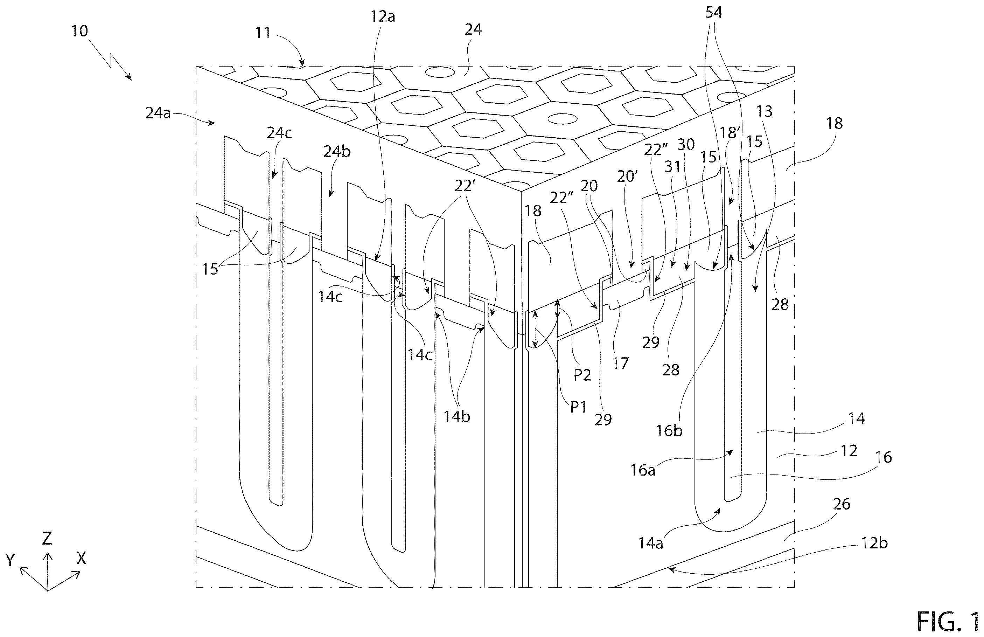

Figure 1 shows an electronic device 10, in detail a power MOSFET. In particular, the electronic device 10 is of the "split-gate" type, also called "shielded-gate" type. The electronic device 10 is hereinafter more simply also referred to as MOSFET 10.

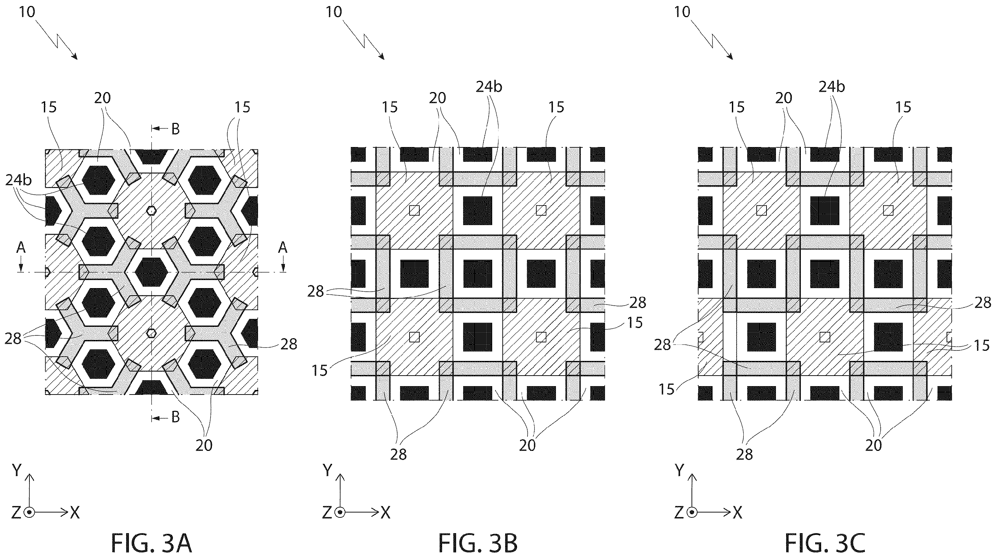

The MOSFET 10 is shown in Figure 1 in cross-section view along two different section lines. In detail, the right section in Figure 1 is taken along the section line A-A shown in Figure 3A, while the left section in Figure 1 is taken along the section line B-B shown in Figure 3A.

In detail, the MOSFET 10 comprises a semiconductor body 12 having a first and a second side (or upper side and lower side) 12a, 12b, opposite to each other along the direction of the Z axis, and a first conductivity type (hereinafter, exemplarily N).

The MOSFET 10 also comprises a plurality of trenches 13 in the semiconductor body 12, at the first side 12a.

As shown in Figures 3A-3C and better described below, in top view (i.e. parallel to an XY plane defined by the axes X and Y) the trenches 13 have a closed polygonal shape (such as a hexagonal shape, square shape, etc.) and are arranged in a matrix.

With reference again to Figure 1, the MOSFET 10 comprises, for each trench 13, a respective oxide region (or insulating field plate region, also called more simply insulating region) 14 extending at the lower and lateral walls of the trench 13.

Each oxide region 14 has an upper surface which, in the present embodiment, is curved, in detail concave. Consequently, each oxide region 14 defines a concavity (also shown below with the reference 54, for example in Figure 54) that has a depth, measured along the direction of the Z axis, that is greater centrally than at the ends (in top view). In detail, the depth of the concavity in the oxide region 14 varies in a substantially continuous manner.

The MOSFET 10 also comprises, for each trench 13, a respective conductive gate region (more simply also gate region) 15 in the trench 13. In detail, the oxide region 14 extends below and around the gate region 15, in such a way that the gate region 15 is electrically insulated from the semiconductor body 12 by means of the oxide region 14.

The lower surface of the gate region 15 has a shape complementary to that of the upper surface of the oxide region 14.

In detail, each gate region 15 has, in the present embodiment, a depth, measured along the direction of the Z axis, that is greater centrally than at the ends. In other words, the gate region 15 has a first depth (or first thickness) P1 at a first region thereof that, in top view, is radially internal and has a second depth (or second thickness) P2 at a second region thereof that, in top view, is radially external and surrounds the first radially internal region; this first depth P1 is greater than the second depth P2.

For purely illustrative and non-limiting purposes, the first depth P1 is comprised between about 0.2 µm and about 0.4 µm and for example is equal to about 0.3 µm and the second depth P2 is comprised between about 0.7 µm and about 0.9 µm and for example is equal to about 0.8 µm.

In other words, in the embodiment of Figure 1, the lower surface of the gate region 15 is curved, in detail convex, in such a way as to be accommodated in the concavity of the respective oxide region 14 and thus to protrude into the oxide region 14 at the first radially internal region. In greater detail, the depth of the bottom surface of the gate region 15 varies in a substantially continuous manner, increasing starting from the second radially external region towards the first radially internal region in such a way as to adapt to the concavity of the oxide region 14.

The MOSFET 10 also comprises, for each trench 13, a respective field plate region 16, of electrically conductive material such as N-doped polysilicon. The field plate region (hereinafter more simply also referred to as field plate) 16 extends in the respective trench 13 and is buried within the oxide region 14, in such a way as to be electrically insulated from the conductive gate region 15 by means of a portion of the oxide region 14.

In detail, a first portion 16a of the field plate 16 extends below the conductive gate region 15 (in particular at the first radially central region of the conductive gate region 15), without being in electrical or physical contact with the latter. Furthermore, a second portion 16b of the field plate 16, continuous with the first portion 16a and superimposed on the latter along the direction of the Z axis, extends within the conductive gate region 15 in such a way as to traverse it along the direction of the Z axis, and is physically and electrically separated from the conductive gate region 15 through a portion of the oxide region 14.

The field plate 16 is used to reduce the electric field in the semiconductor body 12 near the trench 13 and to lower the parasitic capacity.

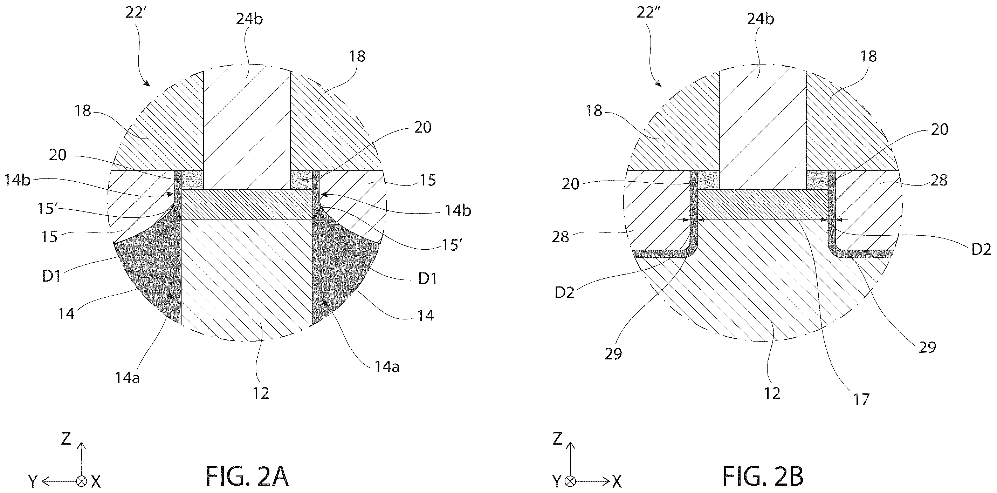

In the present embodiment, each assembly of conductive gate region 15 and corresponding oxide region 14 (in detail, the portion of the oxide region 14 that hereinafter will be indicated with the reference 14b) forms a respective inactive gate structure 22' of the MOSFET 10, through which a conduction channel in use is not generated, as better described below with reference to Figures 2A and 2B. Since the field plates 16 are electrically insulated from the conductive gate regions 15, the inactive gate structures 22' of the MOSFET 10 are known as "shielded-gate" or "split-gate" structures.

The MOSFET 10 further comprises, for each trench 13, a respective upper oxide region 18 extending over the trench 13 and on the conductive gate region 15. In particular, the upper oxide region 18 is not vertically superimposed (i.e. aligned along the direction of the Z axis) with the second portion 16b of the field plate 16; in other words, the upper oxide region 18 has a through opening 18' that traverses it along the direction of the Z axis and that is vertically superimposed on the second portion 16b of the field plate 16.

The MOSFET 10 further comprises, for each trench 13, a respective plurality of body regions 17 having a second conductivity type (here exemplarily of P-type). In particular, the number of body regions 17 for each trench 13 is equal to the number of sides, in top view, of the closed polygonal shape of the trench 13, such that each body region 17 is associated with a respective side of the trench 13, as better described below.

The body regions 17 are accommodated in the semiconductor body 12, laterally to the respective trench 13 and therefore to the radially external region of the respective gate region 15 and extend around the trench 13 in such a way as to surround it without solution of continuity and in such a way as to face the first side 12a of the semiconductor body 12. For example, in the cross-section of Figure 1 two body regions 17 are shown that are adjacent to opposite (along the direction of the Y axis) lateral sides of the trench 13. As better shown in Figure 3A, each body region 17 is therefore interposed, in top view and at the level of the first side 12a of the semiconductor body 12, between two trenches 13 that are first neighboring to each other in the matrix arrangement.

In detail, a portion of the oxide region 14 extends between the body regions 17 and the respective conductive gate region 15, such that the conductive gate region 15 is electrically insulated from the respective body regions 17.

In greater detail, each body region 17 has a lower surface, in contact with the semiconductor body 12, which has a depth, measured along the direction of the Z axis, that is greater than the second depth P2 of the neighboring second radially external region of the gate region 15, as better shown in Figure 2A.

The MOSFET 10 also comprises, for each trench 13, a respective plurality of source regions 20 having the first conductivity type (here exemplarily of N-type). In particular, the number of source regions 20 for each trench 13 is equal to the number of sides, in top view, of the closed polygonal shape of the trench 13, such that each source region 20 is associated with a respective side of the trench 13, as better described below.

Each source region 20 extends on a respective body region 17, at a radially external portion of the latter. In other words, each source region 20 has a through opening 20' that traverses it along the direction of the Z axis and that is vertically superimposed on a radially internal portion (or central portion) of the respective body region 17, in such a way as to expose it. In more detail, in top view, the source region 20 is of annular type and is vertically superimposed on the radially external portion of the respective body region 17, while the radially internal portion of the respective body region 17 is exposed by the through opening 20'.

Accordingly, the source regions 20 are accommodated in the semiconductor body 12, laterally to the respective trench 13, and extend around the trench 13 in such a way as to surround it without solution of continuity and in such a way as to be at the first side 12a of the semiconductor body 12. For example, in the cross-section of Figure 1 two source regions 20 are shown for each trench 13, that are adjacent to opposite (along the direction of the Y axis) lateral sides of the trench 13. As better shown in Figure 3A, each source region 20 is therefore interposed, in top view and at the level of the first side 12a of the semiconductor body 12, between two trenches 13 that are first neighboring to each other in the matrix arrangement.

In detail, the portion of the oxide region 14 that extends between the body regions 17 and the respective conductive gate region 15 also extends between the source regions 20 and the respective conductive gate region 15, such that the conductive gate region 15 is electrically insulated from the respective source regions 20.

The MOSFET 10 also comprises a source metallization 24 that extends on the upper oxide regions 18, on the body regions 17 where exposed by the through openings 20' of the source regions 20, and on the second portions 16b of the field plates 16 where exposed by the through openings 18' of the upper oxide regions 18. In greater detail, the source metallization 24 comprises a main body 24a that extends on the upper oxide regions 18, respective first metallization portions 24b that extend on the respective body regions 17 where exposed by the through openings 20' of the source regions 20, and respective second metallization portions 24c which extend on the second portions 16b of the field plates 16 where exposed by the through openings 18' of the upper oxide regions 18; in particular, the main body 24a extends with solution of continuity both with the first metallization portions 24b and with the second metallization portions 24c. Accordingly, the source metallization 24 is in direct electrical contact with the body regions 17, the source regions 20, and the field plates 16.

In use, the source metallization 24 operates as a source electrode and is biasable to a source voltage V_{S} (e.g., a ground voltage), with which the body regions 17, the source regions 20, and the field plates 16 may be biased.

Furthermore, the MOSFET 10 also comprises a drain metallization 26 that extends in contact with the semiconductor body 12 at the second side 12b.

In use, the drain metallization 26 operates as a drain electrode and is biasable to a drain voltage V_{D}, with which the semiconductor body 12 may be biased.

Furthermore, in a manner not shown, the MOSFET 10 also comprises a gate metallization that extends in contact with the gate regions 15.

In use, the gate metallization operates as a gate electrode and is biasable to a gate voltage V_{G}, with which the gate regions 15 may be biased.

In detail, Figure 1 shows an active area 11 of the MOSFET 10, which includes a plurality of cells, each defined by a respective trench 13. Externally to the active area 11, i.e. beyond an edge termination region (not shown as it is known), a lateral surface of the semiconductor body is present, for example extending substantially orthogonally to the first side. The lateral surface is formed following a dicing step of a SiC wafer wherein a plurality of MOSFETs 10 are formed. The dicing step has the function of separating a MOSFET 10 from another MOSFET 10 of the same wafer. The dicing occurs at a scribe line (not shown) of the SiC wafer from which the MOSFET 10 is obtained. This scribe line surrounds at a distance, in the XY plane, the active area 11, and for example extends externally to a protection ring (not shown) that in top view surrounds the active area 11.

With reference to Figure 1, the MOSFET 10 also comprises gate interconnections 28 that extend between the gate regions 15, in physical and electrical contact therewith, in such a way as to electrically contact them with each other.

In this manner it is possible to have the gate metallization that directly contacts only one part of the gate regions 15 (e.g., those placed at an external perimeter of the active area 11 of the MOSFET 10, in top view), while still allowing the biasing of all the gate regions 15 through the gate interconnections 28.

In particular, the gate interconnections 28 connect gate regions 15 that are arranged side-by-side to each other, in detail that are first neighboring to each other in the matrix arrangement in top view.

In detail, the MOSFET 10 has interconnection trenches 31 that extend in the semiconductor body 12 starting from the first side 12a towards the second side 12b, without reaching the latter. The interconnection trenches 31 communicate with the trenches 13, i.e. they are open on the latter, in such a way as to define an interconnection network that joins the trenches 13 to each other at the level of the first side 12a.

The shape of the interconnection trenches 31 in top view is instead shown and better discussed below with reference to Figures 2A-2B and 3A-3C.

The gate interconnections 28 are accommodated in the interconnection trenches 31 and are electrically insulated with respect to the semiconductor body 12, the source regions 20 and the body regions 17 through insulating interconnection portions 29, of insulating material, which also extend in the interconnection trenches 31. In particular, each insulating interconnection portion 29 extends below, and laterally to, the respective gate interconnection 28, in such a way as to be interposed between the gate interconnection 28 and the semiconductor body 12. In detail, the insulating interconnection portions 29 extend with solution of continuity with the oxide regions 14 to which they are connected.

Accordingly, each gate interconnection 28 forms, together with the respective insulating interconnection portion 29, a respective insulated interconnection structure 30 which is accommodated in the respective interconnection trench 31.

As shown in Figure 1, the gate interconnections 28 extend at the first side 12a of the semiconductor body 12, in particular level with the gate regions 15.

The gate interconnections 28 are continuous with the gate regions 15 to which they are coupled, in particular they are joined to the second radially external regions of the gate regions 15. In more detail, the gate interconnections 28 are of the same material as the gate regions 15 so as to extend with solution of continuity with respect to the latter.

In particular, in the present embodiment the gate interconnections 28 have a depth (or thickness) that is substantially constant and is greater than the second depth P2 of the radially external regions of the gate regions 15. For example, the gate interconnections 28 may have a thickness, measured along the direction of the Z axis, that is about equal to the thickness of the gate regions 15 at their first radially internal region.

Consequently, and as visible in Figure 1, the oxide region 14 protrudes within the assembly formed by gate region 15 and gate interconnection 28 at the point where the gate region 15 and the gate interconnection 28 join. This protrusion of the oxide region 14 does not, however, interrupt the physical and electrical contact between the gate region 15 and the gate interconnection 28.

For purely illustrative and non-limiting purposes, the gate interconnections 28 may have a thickness comprised between about 0.55 µm and about 0.65 µm and a width, measured in the XY plane in a direction orthogonal to the main extension of the gate interconnection 28, comprised between about 0.15 µm and about 0.25 µm. The length of the gate interconnections 28, measured in the XY plane along the main extension of the gate interconnection 28, depends instead in a per se obvious manner on the mutual distance between the trenches 13, as better assumable from the following Figures 3A-3C.

Similarly and again for purely illustrative and non-limiting purposes, the interconnection trenches 31 may have a thickness along the Z axis comprised between about 0.65 µm and about 0.75 µm and a width, measured in the XY plane in a direction orthogonal to the main extension of the interconnection trenches 31, comprised between about 0.25 µm and about 0.35 µm (in other words, the oxide thickness of the insulating interconnection portions 29 is about 50 nm). The length of the interconnection trenches 31, measured in the XY plane along the main extension of the interconnection trenches 31, depends instead in a per se obvious manner on the mutual distance between the trenches 13, as better assumable from the following Figures 3A-3C.

In the present embodiment, each assembly of gate interconnection 28 and insulating interconnection portion 29 further defines a respective active gate structure 22" of the MOSFET 10, through which a conduction channel in use is generated, as better shown with reference to Figures 2A and 2B.

In detail, Figure 2A shows an example of an inactive gate structure 22'.

As is noted in Figure 2A, the second radially external region of the gate region 15 does not reach a depth such as to place it level, along the direction of the Z axis, with the interface between the body region 17 and the semiconductor body 12. In fact, the gate region 15 gets to be level with such interface only at its first radially internal region, where however the width of the oxide of the oxide region 14 that separates the gate region 15 from this interface is significantly greater than the width of the oxide region extending between the second radially external region and the body region 17. In detail, the width of the oxide region 14 that separates the gate region 15 from this interface is such as to locally prevent electrical coupling between the gate region 15 and the body region 17, thus locally preventing the formation of the conduction channel in the inactive gate structure 22'.

Instead, Figure 2B shows an example of an active gate structure 22".

As is noted in Figure 2B, the depth of the gate interconnection 28 is greater than the depth of the interface between the body region 17 and the semiconductor body 12. In other words, the gate interconnection 28 extends laterally both to the body region 17 and to the underlying part of the semiconductor body 12 that is in contact with the body region 17 and with a width of interposed oxide that is substantially uniform and sufficiently small to locally permit electrical coupling between the gate interconnection 28 and the body region 17, thus locally ensuring the formation of the conduction channel in the active gate structure 22". In fact, the insulating interconnection portion 29 that is interposed between the gate interconnection 28 and both the body region 17 and the underlying part of the semiconductor body 12 has a width, for example measured along the direction of the X axis, that is substantially constant and comprised between about 440 nm and about 500 nm, therefore such as to allow in use the localized formation of the conduction channel.

In general, in the present embodiment the gate region 15 has a first minimum distance D1 with respect to the interface between the body region 17 and the semiconductor body 12, while the gate interconnection 28 has a second minimum distance D2 with respect to the interface between the body region 17 and the semiconductor body 12. In detail, the first minimum distance D1 is the minimum distance present between the gate region 15 and the interface between the body region 17 and the semiconductor body 12 (here in particular measured between said interface and the junction point between the lateral surface and the lower surface of the gate region 15), and the second minimum distance D2 is the minimum distance present between the gate interconnection 28 and the interface between the body region 17 and the semiconductor body 12.

The first minimum distance D1 is greater than the second minimum distance D2: in particular, the first minimum distance D1 is equal to at least 50% more than the second minimum distance D2 (i.e. if D2 is equal to K, D1 is equal to at least 1.5K), for example it is equal to 60-70% more than the second minimum distance D2. In detail, the values of the minimum distances D1 and D2 are chosen such that, while the second minimum distance D2 is such as to allow the local formation of the conduction channel, the first minimum distance D1 is such as to inhibit the local formation of the conduction channel.

In the embodiment of Figure 1, this relationship between the minimum distances D1 and D2 is obtained by virtue of the fact that the lower surface of the gate interconnection 28 has a depth, measured with respect to the first side 12a, which is greater than the similar depth (here corresponding to the second depth P2) of the junction point of the gate region 15 between the lateral surface and the lower surface of the gate region 15 (also indicated in Figure 2A with the reference 15'). This, together with the convex shape of the lower surface of the gate region 15, causes the oxide extension between the gate region 15 and the interface between the body region 17 and the semiconductor body 12 to be greater than the oxide extension between the gate interconnection 28 and the interface between the body region 17 and the semiconductor body 12.

The specific values of the first and second minimum distances D1 and D2 obviously depend on the design choices made, such as the materials used and the manufacturing process details. Nonetheless, for illustrative and non-limiting purposes, the first minimum distance D1 may be equal to about 80 nm, while the second minimum distance D2 may be equal to about 50 nm.

Consequently, the simultaneous presence of both the inactive gate structures 22' and the active gate structures 22" allows to obtain a smaller channel perimeter, thus reducing the overall gate-drain capacity and at the same time allowing, by virtue of the cell structure, to have a conduction area greater than what is known (in particular than the known structures with strip gates), and such as to significantly reduce the on-resistance of the MOSFET 10, all in favor of the figure of merit.

The shape and arrangement of the gate interconnections 28 may vary, as shown in Figures 3A-3C.

In detail, Figures 3A-3C show top views of respective embodiments of the MOSFET 10, considered at the level of the first side 12a of the semiconductor body 12.

In the embodiment of Figure 3A, the trenches 13, and therefore also the gate regions 15 and in general the gate structures 22, have a hexagonal shape parallel to the XY plane.

In Figure 3A, each vertex of each gate region 15 is connected to a respective gate interconnection 28, such that each gate interconnection 28 connects to each other three gate regions 15 that are arranged in a triangle in the view of Figure 3A.

In detail, each gate interconnection 28 has three arms, each with a respective first and second end opposite to each other. In each gate interconnection 28, the first ends of the three arms are joined to each other to form a joining portion of the gate interconnection 28. In top view, the three arms extend radially starting from the joining portion, in such a way as to be angularly equi-spaced from each other. The second end of each arm is connected to a respective vertex of one of the three gate regions 15 that, in the top view, surround the gate interconnection 28 considered.

In this manner, each mesa region (defined, in the top view of Figure 3A, by a respective source region 20 which also has, in the view in Figure 3A, a hexagonal shape) has two sides opposite to each other that are in contact with two sides of two respective gate structures 22 first neighboring in the matrix arrangement, and four sides that are in contact two by two with two respective insulated interconnection structures 30 (in detail, a first pair of sides adjacent to each other that are in contact with two respective arms of an insulated interconnection structure 30, and a second pair of sides adjacent to each other that are opposite to the sides of the first pair and are in contact with two respective arms of another insulated interconnection structure 30).

In other words, in Figure 3A the gate interconnections 28 are not directly coupled to each other, but are coupled to each other through the gate regions 15 in such a way as to define an interconnected network of gate regions 15 and gate interconnections 28.

In the embodiment of Figure 3B, the trenches 13, and therefore also the gate regions 15 and in general the gate structures 22, have a square shape parallel to the XY plane and are arranged in such a way as to be aligned with each other both parallel to the X axis and parallel to the Y axis.

In Figure 3B, each vertex of each gate region 15 is connected to a respective gate interconnection 28. The gate interconnections 28 are grouped in groups of four and each group defines a respective square-shaped annular closed path that connects four respective gate regions 15, that are arranged in a 2x2 configuration in the matrix considered.

In detail, each group of gate interconnections 28 comprises two gate interconnections 28 with main extension along the direction of the X axis and two gate interconnections 28 with main extension along the direction of the Y axis. In each group, the ends of the gate interconnections 28 are joined to each other by alternating horizontal gate interconnections 28 with vertical gate interconnections 28, so as to define the square-shaped annular closed path. For each group, the four respective gate regions 15 are each coupled to a respective vertex of the group of gate interconnections 28.

In other words, in Figure 3B the gate interconnections 28 of different groups are not directly coupled to each other, but are coupled to each other through the gate regions 15 in such a way as to define an interconnected network of gate regions 15 and gate interconnections 28.

In the embodiment of Figure 3C, the trenches 13, and therefore also the gate regions 15 and in general the gate structures 22, have a square shape parallel to the XY plane and are arranged in such a way as to be aligned with each other parallel to one axis of the XY plane (here exemplarily parallel to the X axis) and to be aligned with each other in an alternate manner parallel to the other axis of the XY plane (here exemplarily parallel to the Y axis). In other words, the gate regions 15 have a checkerboard arrangement, in top view.

In Figure 3C, each vertex of each gate region 15 is connected to a respective gate interconnection 28 and the gate interconnections 28 are connected to each other in such a way as to form serpentine paths (in detail, square zigzag paths) .

Each serpentine path has a main extension parallel to the X axis and extends, parallel to the Y axis, between two respective rows of gate regions 15 so as to electrically contact the gate regions 15 of these two rows with each other, in detail electrically contacting them one after the other along the serpentine path.

In detail, in each serpentine path the gate interconnections 28 comprise gate interconnections 28 with main extension along the direction of the X axis and gate interconnections 28 with main extension along the direction of the Y axis, that are alternated with each other in such a way as to define this square-type serpentine path. In detail, for each serpentine path the ends of the gate interconnections 28 that are consecutive to each other are joined and are coupled to a vertex of a respective gate region 15.

In other words, in Figure 3C the gate interconnections 28 of a same serpentine path are directly coupled to each other, while the gate interconnections 28 of serpentine paths different from each other are not directly coupled to each other but are coupled to each other through the gate regions 15, so as to define an interconnected network of gate regions 15 and gate interconnections 28.

In view of what has been described so far and returning to Figure 1, it is understood how each oxide region 14 includes a main body (or first portion) 14a that extends below the respective gate region 15 and around the respective field plate 16, a first oxide portion (or second portion) 14b that extends laterally and around the respective gate region 15 (in particular between the gate region 15 and both the semiconductor body 12 and the body region 17 and the source region 20) and a second oxide portion (or third portion) 14c that extends laterally and internally to the respective gate region 15 (in particular between the gate region 15 and both the second portion 16b of the respective field plate 16 and the respective second metallization portion 24c of the source metallization 24). In particular, in each oxide region 14 the respective main body 14a, the respective first oxide portion 14b and the respective second oxide portion 14c extend with solution of continuity between each other.

Furthermore, the insulating interconnection portions 29 extend below, and laterally to, the gate interconnections 28, insulating the gate interconnections 28 from the semiconductor body 12, the source regions 20 and the body regions 17 and allowing instead the electrical contact thereof with the gate regions 15. In particular, the insulating interconnection portions 29 extend with solution of continuity with the oxide regions 14.

As is evident, in use the MOSFET 10 forms a vertical conduction channel, along which the charge carriers move, at the interface between the body region 17 and the gate interconnection 28. This increases the overall channel perimeter compared to known solutions and therefore significantly reduces the on-resistance of the MOSFET 10, as better discussed below.

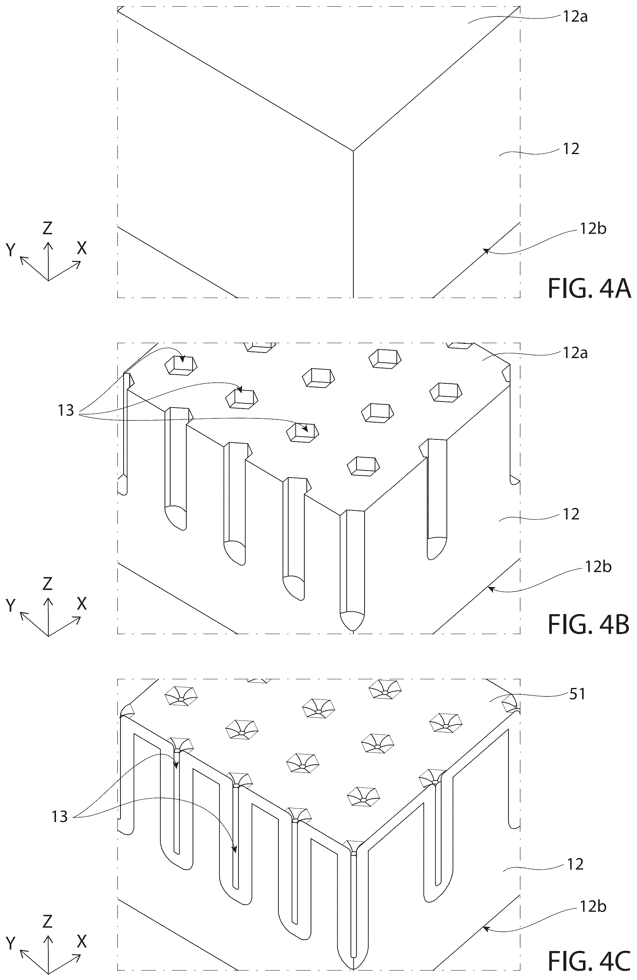

Figures 4A-4M illustrate an embodiment of a process for manufacturing the MOSFET 10 of Figure 1.

In Figure 4A, a semiconductor substrate is provided having an optional epitaxial layer grown thereon. The substrate and the epitaxial layer form, together, the semiconductor body 12. The substrate and the epitaxial layer are, for example, of Silicon having an N-type doping.

Then, Figure 4B, the trenches 13 are formed by etching the semiconductor body 12 from the upper side 12a. The etching is performed by means of known techniques, such as RIE (Reactive Ion Etching) or DRIE (Deep Reactive Ion Etching). In the drawings, the trenches 13 have vertical lateral walls; depending on the process used to manufacture the trenches, they may also have tilted lateral walls, for example, of a truncated V-type shape in side view, or of a truncated inverted pyramid shape. The teaching of the present invention similarly applies also in the case of lateral walls of the trenches 13 not perfectly parallel to the Z axis.

Then, Figure 4C, the trenches 13 are partially filled with insulating electrical material, forming an insulating filling region 51 which is intended to form the main body 14a of the oxide regions 14. This step is performed, for example, by growing or depositing silicon oxide (SiO₂) in case the semiconductor body 12 is of Silicon; another insulating material may be grown or deposited based on the material of the semiconductor body 12.

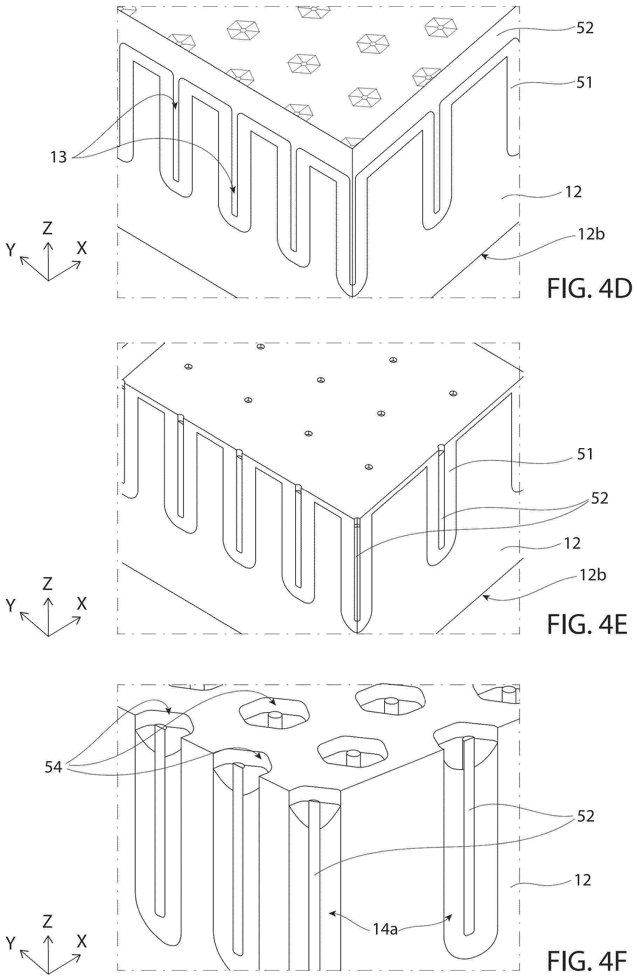

Then, Figure 4D, a step of filling the trenches 13 with conductive material is performed, forming a conductive region 52 in the trenches 13 and on the semiconductor body 12. The conductive material is for example N-doped polysilicon and completely fills the trenches 13. The conductive region 52 is intended to form the field plates 16.

Then, Figure 4E, a step for removing selective portions of the conductive region 52 is performed over the upper side 12a of the semiconductor body 12, preserving the conductive region 52 within the trenches 13.

This step may be performed by means of a CMP (Chemical-Mechanical Polishing) technique, followed by an etching step to partially etch the conductive region 52 within the trenches 13. The conductive region 52 is then recessed in each trench 13 until the conductive region 52 is below the upper side 12a. For example, the recession of the conductive regions 52 in the trenches 13 may have a depth comprised between about 50 nm and about 150 nm, measured starting from the upper side 12a.

Then, Figure 4F, the insulating filling region 51 is partially etched at the upper side 12a, to form a recess 54 in each trench 13. This recess 54 corresponds to the concavity in the oxide region 14 previously described, so its details are not described again here.

The etching is selective towards the material of the insulating filling region 51 and preserves the material of the conductive region 52 in the trenches 13. The portions of the insulating filling region 51 that remain following this etching form the main body 14a of the oxide regions 14.

In detail, this etching exposes one part of the lateral walls of the trenches 13, between the upper side 12a of the semiconductor body 12 and an upper side of the main body 14a of the oxide regions 14. In greater detail, the lateral walls of the trenches 13 are exposed up to a depth, measured along the direction of the Z axis and starting from the upper side 12a, of about 0.3 µm.

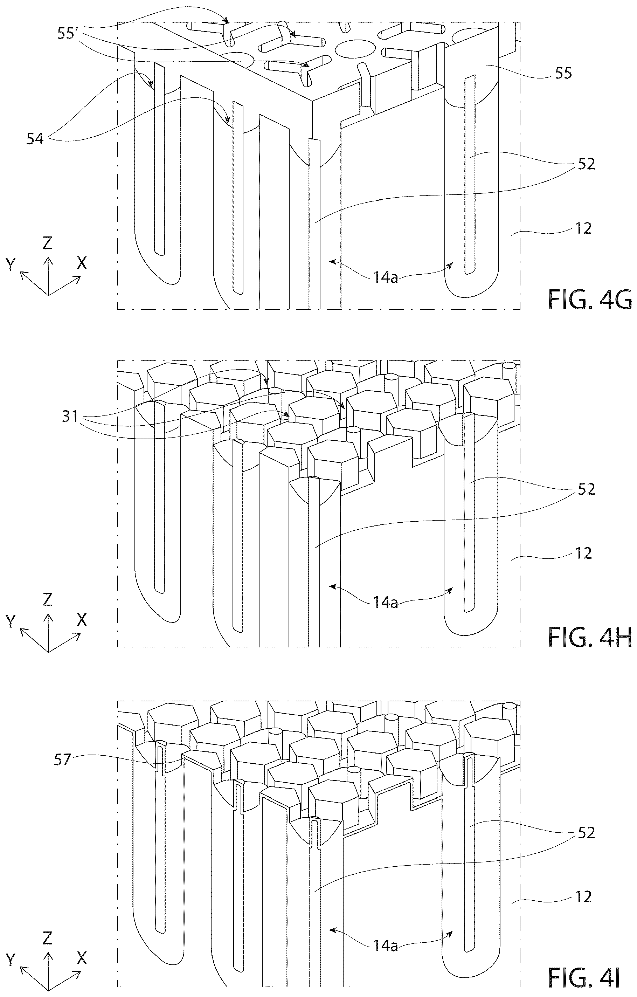

Then, Figure 4G, a mask 55 is formed on the upper side 12a of the semiconductor body 12. The mask 55, for example of polymeric material, covers the trenches 13 and the regions of the upper side 12a of the semiconductor body 12 that are not intended to accommodate the gate interconnections 28. Furthermore, the mask 55 has openings 55' that traverse the mask 55 and expose regions of the upper side 12a of the semiconductor body 12 that are intended to accommodate the gate interconnections 28. In other words, the openings 55' are vertically aligned with respect to where the gate interconnections 28 are intended to be formed; consequently, the openings 55' have a shape and arrangement entirely similar to what has been previously described with reference to the gate interconnections 28.

Then, Figure 4H, an etching step is performed to remove selective portions of the semiconductor body 12 starting from the upper side 12a. This etching step is performed through the mask 55 and forms the interconnection trenches 31 that extend in the semiconductor body 12 starting from the upper side 12a, at the regions that are exposed by the mask 55. Consequently, the interconnection trenches 31 are vertically aligned with the openings 55' and therefore have a shape and arrangement entirely similar to those of the openings 55'. In detail, the ends of the interconnection trenches 31 face the trenches 13 so as to create an interconnection network that connects the trenches 13 to each other.

The etching is interrupted when the interconnection trenches 31 have a depth, with respect to the first side 12a, greater than the depth at which the interface between the body regions 17 and the semiconductor body 12 will subsequently be located. For example, the etching is interrupted when the interconnection trenches 31 have a depth, with respect to the first side 12a, equal to about 0.6 µm. In this manner, the protrusion of the oxide region 14 previously described is formed, which will protrude in the assembly formed by gate region 15 and gate interconnection 28 at the point where the gate region 15 and the gate interconnection 28 will join.

Then, Figure 4I, an oxidation step is performed (e.g. exposing the wafer to an O₂ environment), to form an insulating layer 57 on the exposed surfaces of semiconductor material.

This oxidation step allows the portion of the conductive region 52 that protrudes from, and is therefore not protected by, the insulating filling region 51 in the trenches 13 to be oxidized. This step is self-limiting and allows a buried conductive region to be formed in each trench 13. Each of these buried conductive regions forms one of the field plates 16 previously discussed. In detail, for each trench 13, the portion of the conductive region 52 that is protected by the insulating filling region 51 forms the first portion 16a of the field plate 16, while the portion of the conductive region 52 that protrudes from the insulating filling region 51 and that remains following oxidation forms the second portion 16b of the field plate 16. Furthermore, for each trench 13, the portion of the conductive region 52 that protrudes from the insulating filling region 51 and that is oxidized is intended to form the second oxide portion 14c.

This same oxidation step also causes the oxidation of the semiconductor material in the interconnection trenches 31 and on the remaining exposed parts of the upper side 12a of the semiconductor body 12, in detail on the exposed regions of the lateral walls of the trenches 13. In particular, the oxidized regions of the interconnection trenches 31 form the insulating interconnection portions 29 previously described, while the oxidized regions of the lateral walls of the trenches 13 form the first oxide portions 14b previously described.

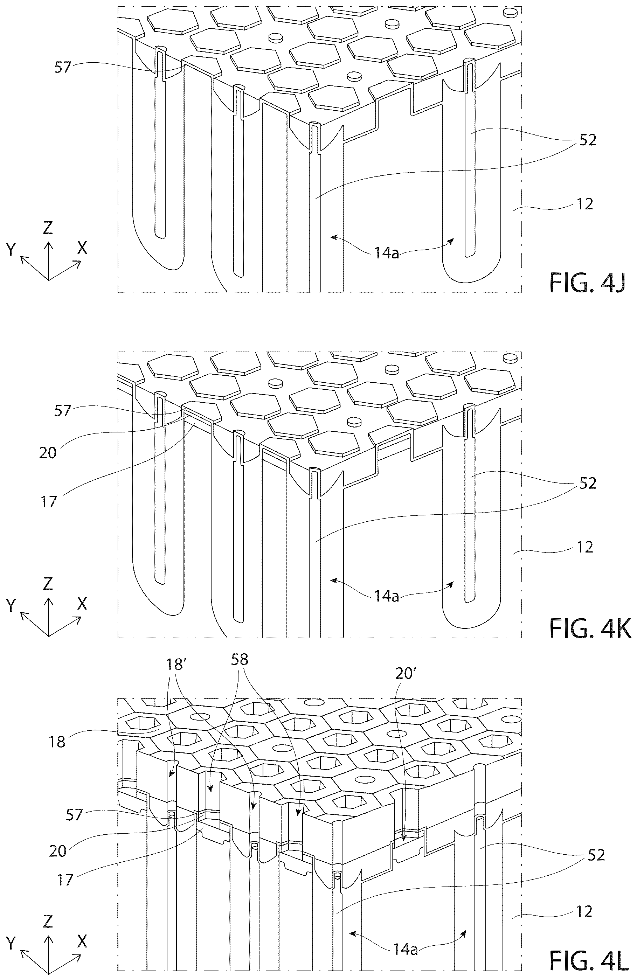

Then, Figure 4J, a formation step of the gate regions 15 and the gate interconnections 28 is performed. The gate regions 15 are formed by depositing conductive material (e.g., n-doped polysilicon) in the recesses 54, while the gate interconnections 28 are formed by depositing the same conductive material (e.g., n-doped polysilicon) in the interconnection trenches 31.

Then, Figure 4K, the body regions 17 and the source regions 20 are formed by means of known implants of P-type and N-type doping species, respectively, in the semiconductor regions between the trenches 13.

Then, Figure 4L, the upper oxide regions 18 are formed on the gate regions 15 and the gate interconnections 28.

In detail, an upper oxide layer is first formed, for example through deposition, that uniformly covers the gate regions 15, the gate interconnections 28, the source regions 20 and the field plates 16. The upper oxide layer is then etched both between the trenches 13, to form contact openings 58 wherein the first metallization portions 24b will extend, and over the field plates 16, to form the through openings 18' wherein the second metallization portions 24c will extend. Furthermore, again with reference to Figure 4L, the through openings 20' are also formed that expose the radially internal portions of the body regions 17; this is done through a further etching that is selective towards the semiconductor material and that does not etch the material of the upper oxide layer. In particular, the contact openings 58 are superimposed on the through openings 20'. Furthermore, the through openings 18' expose the upper surfaces of the second portions 16b of the field plates 16.

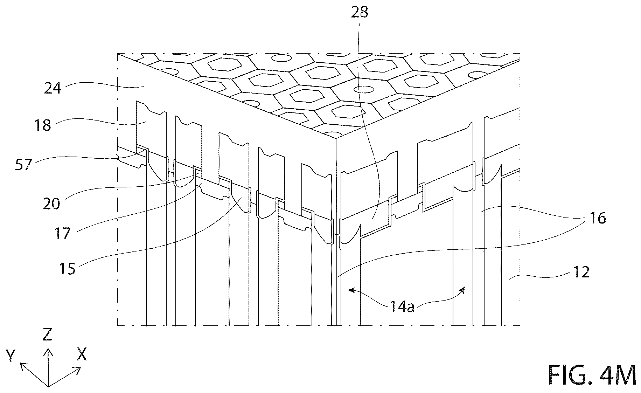

Then, Figure 4M, the source metallization 24 is formed, for example through deposition of conductive material. In detail, a layer of conductive material is deposited uniformly on the upper oxide regions 18 to form the main body 24a, in the contact openings 58 to form the first metallization portions 24b, and in the through openings 18' to form the second metallization portions 24c. Consequently, the first metallization portions 24b are in contact with the body regions 17 and the source regions 20, while the second metallization portions 24c are in contact with the field plates 16.

To complete the manufacture of the MOSFET 10, other steps may be performed that are not further described as they are not part of the present invention.

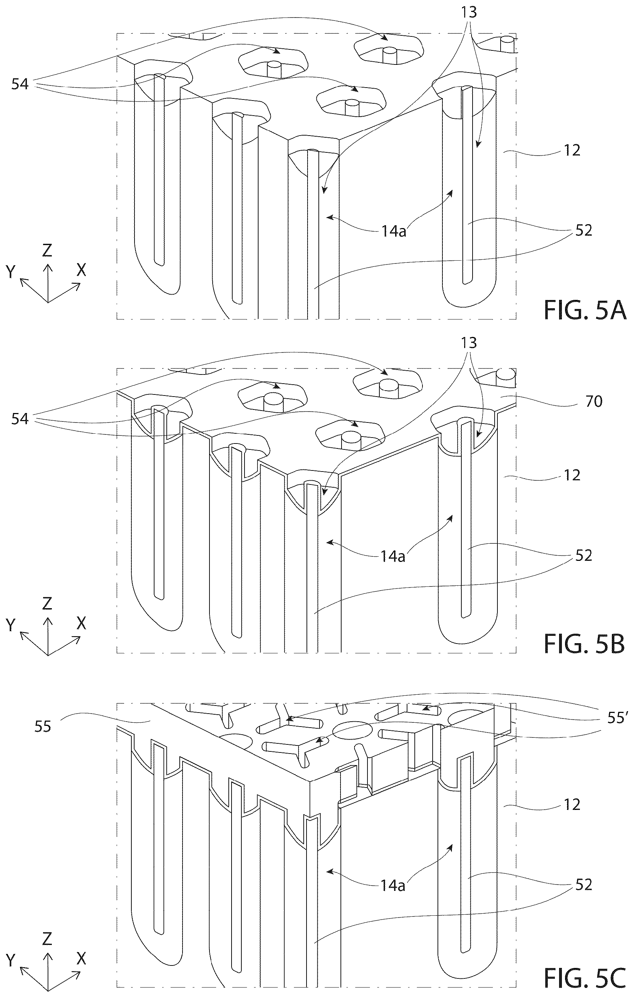

Figures 5A-5H illustrate a different embodiment of the process for manufacturing the MOSFET 10 of Figure 1.

In particular, in this embodiment the manufacturing process initially comprises the same steps previously described with reference to Figures 4A-4F, which for this reason are not described again in detail here.

Then, Figure 5A, there is the semiconductor body 12 with the trenches 13 having the recessed portions of the insulating filling region 51 and the conductive region 52 therewithin and with the recesses 54 formed in the recessed portions of the insulating filling region 51.

Then, Figure 5B, a first intermediate insulating layer 70 is formed that covers the recessed portions of the insulating filling region 51 and the conductive region 52 and the exposed regions of the semiconductor body 12.

For example, this occurs through deposition of oxide material such as TEOS, for example with a thickness equal to about 100 nm.

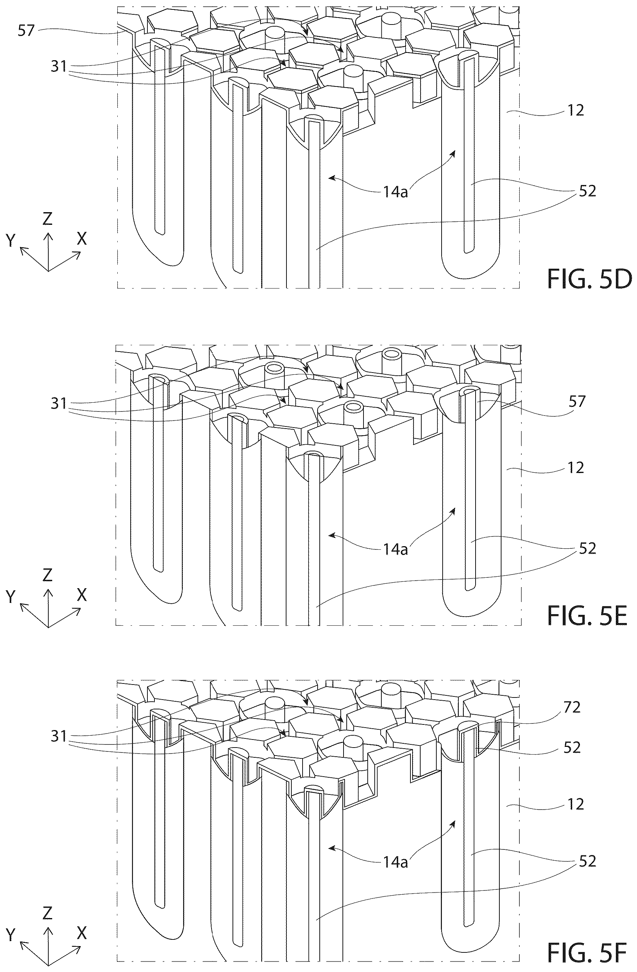

Then, Figures 5C and 5D, the interconnection trenches 31 are formed similarly to what has been previously described with reference to Figures 4G and 4H. Accordingly, this is again not described in detail except for specifying that the formation of the interconnection trenches 31 is performed with a succession of etchings through the openings 55' of the mask 55, in particular through a first etching (Figure 5C) that selectively removes the parts of the first intermediate insulating layer 70 exposed by the mask 55 and a second etching (Figure 5D) that removes the underlying parts of the semiconductor body 12.

Then, Figure 5E, parts of the first intermediate insulating layer 70 are selectively removed, leaving the portions of the latter that extend vertically (i.e. along the vertically arranged surfaces). In detail, the portions of the intermediate insulating layer 70 that extend on the upper side 12a of the semiconductor body 12, on the upper ends of the recessed portions of the conductive regions 52 and above the recessed portions of the insulating filling region 51 are removed, maintaining instead the portions of the first intermediate insulating layer 70 that extend on the lateral walls of the recessed portions of the conductive regions 52 and on the lateral walls of the trenches 13.

This is done through an anisotropic etching (in detail of a dry-type), that removes the portions of the first intermediate insulating layer 70 that extend horizontally and instead maintains the remaining parts that extend vertically.

Then, Figure 5F, a second intermediate insulating layer 72 is formed that uniformly covers the recessed portions of the insulating filling region 51, the exposed regions of the semiconductor body 12 and the recessed portions of the conductive regions 52, and the remaining portions of the first intermediate insulating layer 70.

For example, this occurs through an oxidation step with a sacrificial oxide, for example with a thickness equal to about 55 nm.

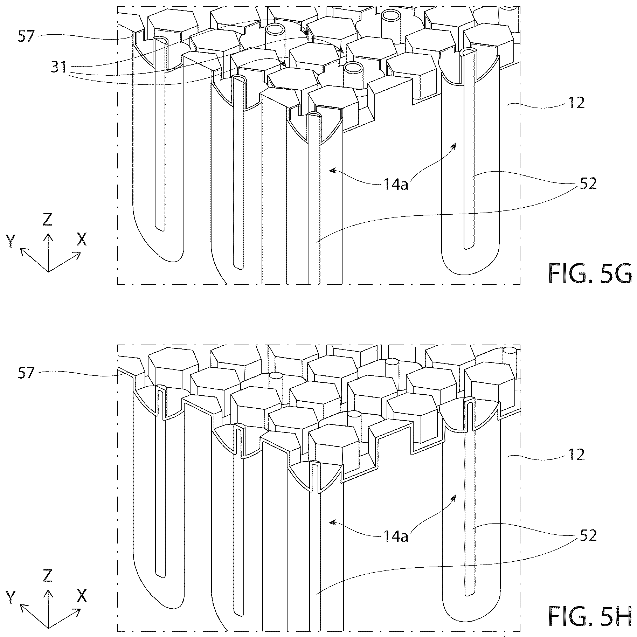

Then, Figure 5G, the oxide parts are selectively etched, to reduce the overall thickness thereof. In particular, an etching, in detail of the isotropic type, is performed to reduce the thickness of the second intermediate insulating layer 72 until the oxide barrier interposed between the recesses 54 and the interconnection trenches 31 is removed, allowing its direct fluidic communication and therefore, subsequently, allowing the electrical connection between the conductive gate regions 15 and the gate interconnections 28. For example, the etching of Figure 5G removes an oxide thickness of about 65 nm: since the etching acts simultaneously on both sides of this oxide barrier interposed between the recesses 54 and the interconnection trenches 31 (i.e. both on the side of the recess 54 and on the side of the interconnection trench 31), it removes this barrier entirely.

Then, Figure 5H, an oxidation step is performed (e.g. by exposing the wafer to an O₂ environment), to form an insulating layer 57 on the exposed surfaces of semiconductor material, similarly to what has already been previously described with reference to Figure 4I.

Then steps follow that are completely similar to those previously described with reference to Figures 4J-4M and that therefore are not described again in detail.

To complete the manufacturing of the MOSFET 10, other steps may be performed that are not further described as they are not part of the present invention.

In detail, the steps of Figures 5B-5H allow a more accurate control of the insulation of the gate regions 15 with respect to the source metallization 24 at the point where the latter contacts the field plates 16, with respect to the solution of Figures 4A-4M.

In more detail, by virtue of these steps, the second oxide portion 14c that has an annular shape and surrounds the respective second metallization portion 24c has, orthogonally to the Z axis, a width greater than a minimum width that is equal to or greater than about 50 nm, in particular equal to about 100nm.

Furthermore, the greater thickening of the oxide portions 14b and 14c leads to a greater insulation robustness and to a lower gate-source capacity C_{gs}, which translates into a lower input capacity Cᵢ and into greater efficiency and lower power losses during switching.

From an examination of the characteristics of the invention made according to the present invention, the advantages that it affords are evident.

In particular, the MOSFET 10 of the split-gate type allows the on-resistance to be reduced without having to resize the diffusion process or increase the lithographic resolution, thus saving costs and difficulties during the manufacturing step. In particular, this occurs by virtue of a significant increase in the conduction area (e.g., about 60% more), obtained through the use of the trenches 13 being cell-shaped instead of strip-shaped, and at the same time avoiding the increase in the gate-drain capacity through the use of the gate interconnections 28 as active channels, thus maximizing the gain on the figure of merit.

Finally, it is clear that modifications and variations may be made to the invention described and illustrated here without thereby departing from the scope of the present invention, as defined in the attached claims.

For example, the different embodiments described may be combined with each other to provide further solutions.

Furthermore, the present solution may be applied to any type of trench-gate vertical conduction device, such as, but not limited to, a VDMOS transistor, or a trench-based power MOSFET device.

Furthermore, other shapes and arrangements may be used, as an alternative to what has been exemplarily shown in Figures 3A-3C. For example, the square shapes of Figures 3A-3C may be replaced by more generic quadrangular shapes, such as for example rectangular or rhomboid shapes.

Furthermore, according to a different embodiment each oxide region 14 has an upper surface that is substantially flat. Consequently, each gate region 15 has a lower surface, in contact with the oxide region 14, that has a depth, measured along the direction of the Z axis, that is substantially constant and for example equal to the second depth P2 previously described.

In this case, the relationship previously described between the minimum distances D1 and D2 is maintained by virtue of the difference between the depth of the lower surface of the gate interconnection 28 with respect to the first side 12a and the depth of the junction point of the gate region 15 between the lateral surface and the lower surface of the gate region 15 with respect to the first side 12a. In fact, having a difference between these depths that is sufficiently large still allows for the first minimum distance D1 to be greater than the second minimum distance D2.

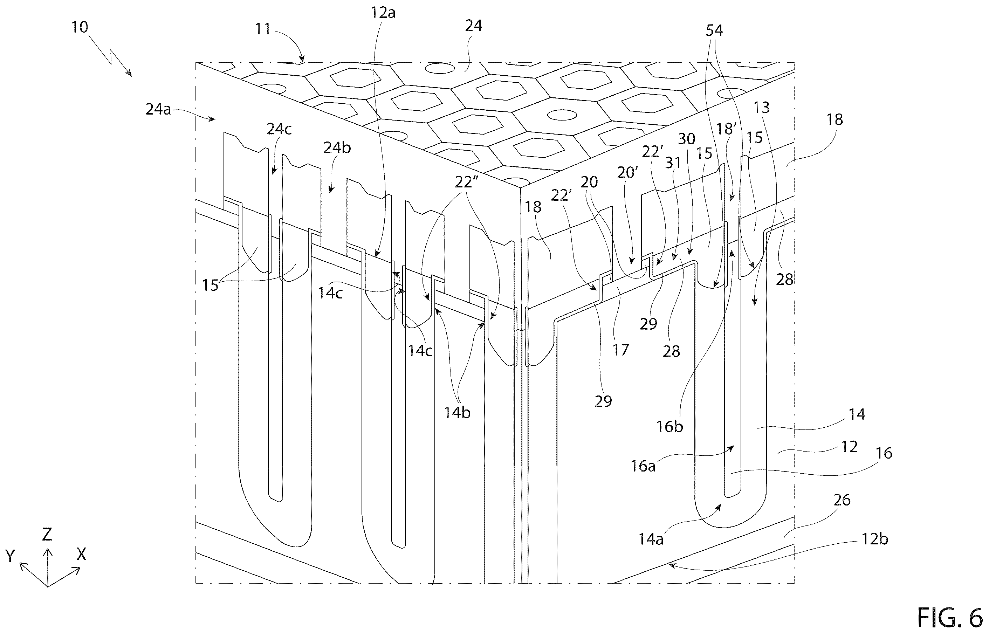

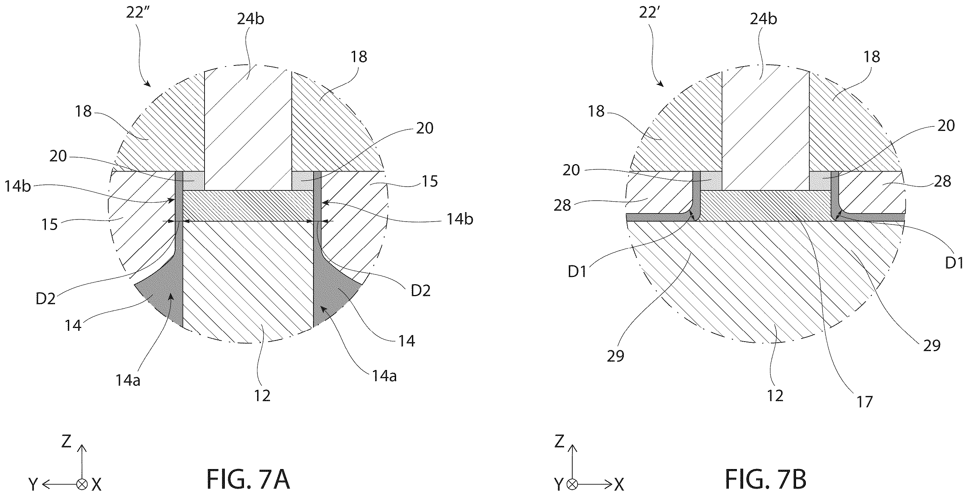

Furthermore, Figure 6 and Figures 7A and 7B show a different embodiment of the MOSFET 10.

As is noted, the MOSFET 10 of Figure 6 is similar to the MOSFET 10 of Figure 1, therefore it is not described in detail here again except for highlighting the differences with respect to the case previously described.

In particular, in the embodiment of Figure 6 and 7A and 7B, the inactive and active gate structures 22' and 22" are reversed with respect to what has been previously described and shown in Figures 1 and 2A and 2B. In detail, each inactive gate structure 22' of the MOSFET 10 (Figure 7B), through which a conduction channel in use is not generated, is here defined by a respective assembly of gate interconnections 28 and related insulating interconnection portion 29, while each active gate structure 22" of the MOSFET 10 (Figure 7A), through which a conduction channel in use is generated, is here defined by a respective assembly of conductive gate region 15 and related oxide region 14 (in particular, related first oxide portion 14b).

This is possible by reversing the design criteria for the depth of the conductive gate regions 15 and the gate interconnections 28: in this case, the depth of each conductive gate region 15 with respect to the first side 12a is greater than the depth of each gate interconnection 28 with respect to the first side 12a. The lower surface of the conductive gate regions 15 may be curved, in detail concave, or substantially planar, similarly to what has been previously described.

This diversity in depths causes a corresponding diversity between the first minimum distance D1 (here defined as the minimum distance between the gate interconnection 28 and the relative interface between the body region 17 and the semiconductor body 12) and the second minimum distance D2 (here defined as the minimum distance between the conductive gate region 15 and the relative interface between the body region 17 and the semiconductor body 12), i.e. that the first minimum distance D1 is greater than the second minimum distance D2 and, in particular, that the first minimum distance D1 is equal to at least 50% more than the second minimum distance D2.

As already described previously, this ensures that in use conduction is generated in the active gate structures 22" but not in the inactive gate structures 22'.

As is evident, the two variants of manufacturing process previously described are usable in a completely similar manner also for manufacturing the MOSFET 10 of Figure 6, by reversing the depths of the material removals used to form the conductive gate regions 15 and the gate interconnections 28 with respect to what has been previously described. For this reason, the manufacturing process for this MOSFET 10 is not described again now, but instead reference is made to the preceding description.

## Claims

1. An electronic device (10), comprising:
a semiconductor body (12), with a first conductivity type (N), having a first and a second side (12a, 12b) opposite to each other along a first axis (Z);
a plurality of trenches (13) extending within the semiconductor body (12) from the first side (12a) towards the second side (12b) and terminating within the semiconductor body (12);
a respective insulating region (14) in each of said trenches (13), covering the lower and lateral walls of the respective trench (13);
a respective conductive gate region (15) in each of said trenches (13) on a respective first portion (14a) of the respective insulating region (14), each conductive gate region (15) being of conductive material and being electrically insulated from the semiconductor body (12) by means of a respective second portion (14b) of the respective insulating region (14);
a respective field plate region (16) in each of said trenches (13), each field plate region (16) being buried in the respective first portion (14a) of the respective insulating region (14) and being electrically insulated from the respective conductive gate region (15) and the semiconductor body (12) by means of a respective third portion (14c) of the respective insulating region (14);
a plurality of gate interconnections (28) extending within the semiconductor body (12) from the first side (12a) towards the second side (12b), laterally to the trenches (13), and terminating within the semiconductor body (12), the gate interconnections (28) being of conductive material, being electrically insulated from the semiconductor body (12) and being electrically connected to the conductive gate regions (15) in such a way as to electrically interconnect the conductive gate regions (15) with each other; and
a plurality of body regions (17) extending at the first side (12a) between the trenches (13), the body regions (17) having a second conductivity type (P) opposite to the first conductivity type (N), being lateral to the gate interconnections (28) and the conductive gate regions (15) and being electrically insulated with respect to the gate interconnections (28) and the conductive gate regions (15),
wherein the ones of the conductive gate regions (15) and the gate interconnections (28) are part of respective inactive gate structures (22') of the electronic device (10), configured to locally inhibit the formation of a conduction channel through the body regions (17), and the others of the conductive gate regions (15) and the gate interconnections (28) are part of respective active gate structures (22") of the electronic device (10), configured to locally allow the formation of a conduction channel through the body regions (17).

2. The electronic device according to claim 1, wherein the ones of the conductive gate regions (15) and the gate interconnections (28) each have a respective first minimum distance (D1) from an interface between the respective body region (17) and the semiconductor body (12) and wherein the others of the conductive gate regions (15) and the gate interconnections (28) each have a respective second minimum distance (D2) from an interface between the respective body region (17) and the semiconductor body (12), the first minimum distance (D1) being greater than the second minimum distance (D2).

3. The electronic device according to claim 2, wherein the first minimum distance (D1) is equal to at least 50% more than the second minimum distance (D2).

4. The electronic device according to any of the preceding claims, further comprising a plurality of interconnection trenches (31), each interconnection trench (31) extending within the semiconductor body (12) from the first side (12a) towards the second side (12b) and terminating within the semiconductor body (12),
wherein the interconnection trenches (31) are interposed, orthogonally to the first axis (Z), between the trenches (13) and are communicating with the trenches (13),
wherein the gate interconnections (28) extend within the interconnection trenches (31) in such a way as to electrically contact the conductive gate regions (15) with each other,
the electronic device (10) further comprising insulating interconnection portions (29), of insulating material, which extend in the interconnection trenches (31) in such a way as to be interposed between the gate interconnections (28) and both the semiconductor body (12) and the body regions (17) to electrically insulate the gate interconnections (28) from the body regions (17) and from the semiconductor body (12).

5. The electronic device according to any of the preceding claims, wherein each insulating region (14) has a respective upper surface of the curved type that defines a respective concavity (54),
wherein each conductive gate region (15) extends in the respective concavity (54),
wherein each conductive gate region (15) has a first depth (P1), the maximum depth, at a first region of the conductive gate region (15) which orthogonally to the first axis (Z) is radially internal, and has a second depth (P2), the minimum depth, at a second region of the conductive gate region (15) which orthogonally to the first axis (Z) is radially external and surrounds said first radially internal region, the first region and the second region being continuous with each other, the first depth (P1) and the second depth (P2) being measured parallel to the first axis (Z) starting from an upper surface of the conductive gate region (15),
the first depth (P1) being greater than the second depth (P2) and the depth of the conductive gate region (15) varying continuously between the first depth (P1) and the second depth (P2).

6. The electronic device according to any of the preceding claims, wherein, orthogonally to the first axis (Z), the trenches (13) have a closed polygonal shape and a matrix arrangement.

7. The electronic device according to claim 6, wherein the number of body regions (17) for each trench (13) is equal to the number of sides, in top view, of the closed polygonal shape of the trench (13), such that each body region (17) is associated with a respective side of the trench (13),
the electronic device further comprising, for each trench (13), a respective plurality of source regions (20) having the first conductivity type and extending on a respective body region (17) of the body regions (17), the number of source regions (20) for each trench (13) being equal to the number of sides, in top view, of the closed polygonal shape of the trench (13), such that each source region (20) is associated with a respective side of the trench (13),
wherein the gate interconnections (28) are physically and electrically connected to the respective conductive gate regions (15),
wherein each gate interconnection (28) connects a least one vertex of one of the conductive gate regions (15) to at least one vertex of an adjacent conductive gate region (15) of the conductive gate regions (15) and to another vertex of another adjacent conductive gate region (15) of the conductive gate regions (15).

8. The electronic device according to claim 6 or 7, wherein one of the following configurations a-c applies:
a:
the trenches (13) and the conductive gate regions (15) have a hexagonal shape orthogonally to the first axis (Z),
wherein each gate interconnection (28) connects to each other three respective gate regions (15) that are first neighboring to each other in the matrix arrangement,
wherein each gate interconnection (28) has three respective arms, each arm having a respective first and a respective second end opposite to each other with respect to the direction of main extension of the arm, the first ends of the arms of each gate interconnection (28) being joined to each other to form a joining portion of the gate interconnection (28), starting from which the respective three arms extend radially in such a way as to be angularly equi-spaced from each other orthogonally to the first axis (Z),
wherein the second end of each arm of each gate interconnection (28) is coupled to a respective vertex of a respective of the three gate regions (15) that, in the matrix arrangement, surround the respective gate interconnection (28),
b:
the trenches (13) are aligned with each other, in the matrix arrangement, both along a second axis (X) orthogonal to the first axis (Z) and along a third axis (Y) orthogonal to both the first axis (Z) and the second axis (X),
wherein the trenches (13) and the conductive gate regions (15) have a quadrilateral shape, in particular a square shape, orthogonally to the first axis (Z),
wherein the gate interconnections (28) are grouped in groups each of four respective gate interconnections (28), each group of gate interconnections (28) connecting to each other four respective gate regions (15) that are first neighboring to each other in the matrix arrangement,
wherein each group of gate interconnections (28) forms a conductive path that, orthogonally to the first axis (Z), is of an annular type and has a quadrilateral shape, in particular a square shape,
wherein each vertex of the quadrilateral shape of each conductive path is connected to a respective vertex of a respective of the four gate regions (15) that, in the matrix arrangement, surround the respective group of gate interconnections (28),
c:
the trenches (13), in the matrix arrangement, are aligned with each other along a second axis (X) orthogonal to the first axis (Z) and are aligned with each other alternately along a third axis (Y) orthogonal to both the first axis (Z) and the second axis (X),
wherein the trenches (13) and the conductive gate regions (15) have a quadrilateral shape, in particular a square shape, orthogonally to the first axis (Z),
wherein the gate interconnections (28) are grouped to form serpentine paths of gate interconnections (28), each serpentine path having a main extension along the direction of the second axis (X) and extending, along the direction of the third axis (Y), between two respective rows of conductive gate regions (15), each row comprising respective conductive gate regions (15) that are aligned with each other along the direction of the second axis (X),
each serpentine path being coupled to vertices of the respective conductive gate regions (15) in such a way as to couple to each other, in succession, the conductive gate regions (15) of said two respective rows having the serpentine path interposed therebetween.

9. The electronic device according to claim 7 or claim 8 when depending on claim 7, further comprising:
a gate metallization that is located at the first side (12a) of the semiconductor body (12) and is directly electrically connected to one part of the conductive gate regions (15);
a source metallization (24) that is located at the first side (12a) of the semiconductor body (12) and is electrically connected to the source regions (20) and the field plate regions (16); and
a drain metallization (26) that is located at the second side (12b) of the semiconductor body (12).

10. The electronic device according to claim 9, wherein the source metallization (24) has a respective metallization portion (24c) for each trench (13), each metallization portion (24c) extending through the respective conductive gate region (15) along the direction of the first axis (Z) up to reaching the respective field plate region (16),
wherein each metallization portion (24c) is electrically insulated with respect to the respective conductive gate region (15) through the respective third portion (14c) of the insulating region (14) which, orthogonally to the first axis (Z), has annular shape, surrounds the respective metallization portion (24c) and has a width greater than a minimum width equal to 50 nm.

11. The electronic device according to any of the preceding claims, being of the vertical conduction type.

12. A process for manufacturing an electronic device (10), comprising the steps of:
forming a plurality of trenches (13) within a semiconductor body (12), the semiconductor body (12) having a first and a second side (12a, 12b) opposite to each other along a first axis (Z), the trenches (13) extending from the first side (12a) towards the second side (12b) and terminating within the semiconductor body (12);
forming a respective insulating region (14) in each of said trenches (13), covering the lower and lateral walls of the respective trench (13);
forming a respective field plate region (16) in each of said trenches (13), each field plate region (16) being buried in a respective first portion (14a) of the respective insulating region (14) and being electrically insulated from the semiconductor body (12) by means of a respective third portion (14c) of the respective insulating region (14);
forming a respective conductive gate region (15) in each of said trenches (13) on the respective first portion (14a) of the respective insulating region (14), each conductive gate region (15) being of conductive material and being electrically insulated from the semiconductor body (12) and the respective field plate region (16) by means of a respective second portion (14b) of the respective insulating region (14);
forming a plurality of gate interconnections (28) extending within the semiconductor body (12) from the first side (12a) towards the second side (12b), laterally to the trenches (13), and terminating within the semiconductor body (12), the gate interconnections (28) being of conductive material, being electrically insulated from the semiconductor body (12) and being electrically connected to the conductive gate regions (15) in such a way as to electrically interconnect the conductive gate regions (15) with each other; and
forming a plurality of body regions (17) extending at the first side (12a) between the trenches (13), the body regions (17) having a second conductivity type (P) opposite to the first conductivity type (N), being lateral to the gate interconnections (28) and the conductive gate regions (15) and being electrically insulated with respect to the gate interconnections (28) and the conductive gate regions (15),
wherein the ones of the conductive gate regions (15) and the gate interconnections (28) are part of respective inactive gate structures (22') of the electronic device (10), configured to locally inhibit the formation of a conduction channel through the body regions (17), and the others of the conductive gate regions (15) and the gate interconnections (28) are part of respective active gate structures (22") of the electronic device (10), configured to locally allow the formation of a conduction channel through the body regions (17) .

13. The manufacturing process according to claim 12, further comprising, after the step of forming the field plate regions (16), the steps of:
partially etching a respective insulating filling region (51) in each trench (13) at the first side (12a), to form a recess (54) in each trench (13) and define a main body (14a) of each insulating region (14);
selectively removing portions of the semiconductor body (12) starting from the first side (12a) to form interconnection trenches (31), each interconnection trench (31) extending within the semiconductor body (12) from the first side (12a) towards the second side (12b) and terminating within the semiconductor body (12), the interconnection trenches (31) being interposed, orthogonally to the first axis (Z), between the trenches (13) and being communicating with the trenches (13); and
forming an insulating layer (57) in the interconnection trenches (31) and the recesses (54), the portions of the insulating layer (57) present in the interconnection trenches (31) defining insulating interconnection portions (29) that extend in the interconnection trenches (31), and
wherein the step of forming the conductive gate regions (15) and the step of forming the gate interconnections (28) are performed simultaneously by depositing conductive material in the recesses (54) and in the interconnection trenches (31), respectively, such that the insulating interconnection portions (29) are interposed between the gate interconnections (28) and the semiconductor body (12) in the interconnection trenches (31).

14. The manufacturing process according to claim 12, further comprising, after the step of forming the field plate regions (16), the steps of:
partially etching a respective insulating filling region (51) in each trench (13) at the first side (12a), to form a recess (54) in each trench (13);
forming a first intermediate insulating layer (70) in the recesses (54) and on the exposed regions of the semiconductor body (12);
selectively removing portions of the semiconductor body (12) starting from the first side (12a) to form interconnection trenches (31), each interconnection trench (31) extending within the semiconductor body (12) from the first side (12a) towards the second side (12b) and terminating within the semiconductor body (12), the interconnection trenches (31) being interposed, orthogonally to the first axis (Z), between the trenches (13) and being communicating with the trenches (13);
selectively removing parts of the first intermediate insulating layer (70), leaving the portions of the first intermediate insulating layer (70) that extend on lateral walls of the field plate regions (16) and on the lateral walls of the trenches (13);
forming a second intermediate insulating layer (72) on the recessed portions of the insulating filling region (51), on exposed regions of the semiconductor body (12) and field plate regions (16), and on the remaining portions of the first intermediate insulating layer (70);
selectively removing part of the second intermediate insulating layer (72) to put in direct communication the recesses (54) and the interconnection trenches (31); and
forming an insulating layer (57) in the interconnection trenches (31) and the recesses (54), the portions of the insulating layer (57) present in the interconnection trenches (31) defining insulating interconnection portions (29) that extend in the interconnection trenches (31), and
wherein the step of forming the conductive gate regions (15) and the step of forming the gate interconnections (28) are performed simultaneously by depositing conductive material in the recesses (54) and in the interconnection trenches (31), respectively, such that the insulating interconnection portions (29) are interposed between the gate interconnections (28) and the semiconductor body (12) in the interconnection trenches (31).

15. The manufacturing process according to claim 13 or 14, wherein, if the conductive gate regions (15) are part of the inactive gate structures (22') and the gate interconnections (28) are part of the active gate structures (22"), the gate interconnections (28) each have a respective lower surface at a depth with respect to the first side (12a) and along the first axis (Z) that is greater than a depth with respect to the first side (12a) and along the first axis (Z) of an interface between the respective body region (17) and the semiconductor body (12), and the conductive gate regions (15) each have a respective lower surface at a minimum depth with respect to the first side (12a) and along the first axis (Z) that is lower than a depth with respect to the first side (12a) and along the first axis (Z) of an interface between the respective body region (17) and the semiconductor body (12), or
wherein, if the gate interconnections (28) are part of the inactive gate structures (22') and the conductive gate regions (15) are part of the active gate structures (22"), the gate interconnections (28) each have a respective lower surface at a depth with respect to the first side (12a) and along the first axis (Z) that is lower than a depth with respect to the first side (12a) and along the first axis (Z) of an interface between the respective body region (17) and the semiconductor body (12), and the conductive gate regions (15) each have a respective lower surface at a minimum depth with respect to the first side (12a) and along the first axis (Z) that is greater than a depth with respect to the first side (12a) and along the first axis (Z) of an interface between the respective body region (17) and the semiconductor body (12).
